# EUROPÄISCHE PATENTSCHRIFT

(11) **EP 1 052 773 B1**
(45) Veröffentlichungstag und Bekanntmachung des Hinweises auf die Patenterteilung: **21.12.2005**
(21) Anmeldenummer: 00109444.0
(22) Anmeldetag: 03.05.2000
(51) Int. Cl.: H03K 17/567

(54) **Integrierter Schaltkreis zur Erzeugung eines Ansteuersignals für einen Bipolartransistor mit isoliertem Gate (IGBT)**
Integrated switching circuit for generating a control signal for an insulated gate bipolar transistor (IGBT)
Circuit de commutation intégré servant à la génération d'un signal de commande pour un transistor bipolaire à grille isolée (IGBT)

(30) Priorität: 12.05.1999 DE 19922128
(43) Veröffentlichungstag der Anmeldung: 15.11.2000
(73) Patentinhaber: SIEMENS AKTIENGESELLSCHAFT, 80333 München (DE)
(72) Erfinder: Munz, Dieter, Dipl.-Ing. (FH), 91315 Höchstadt (DE); Günther, Harald, Dipl.-Ing., 90537 Feucht (DE); Staudt, Michael, Dipl.-Ing. (FH), 90469 Nürnberg (DE)

(56) Entgegenhaltungen:
- EP-A- 0 875 995
- WO-A-99/08263
- DE-A- 1 562 171
- US-A- 3 631 451
- US-A- 3 829 719
- US-A- 5 399 965

## Beschreibung

Die Erfindung betrifft einen integrierten Schaltkreis zur Erzeugung eines Ansteuersignals für einen IGBT.

Um beispielsweise unter Verwendung eines Mikrocontrollers Gleichstrom- oder Wechselstrommotoren anzusteuern, werden galvanisch getrennte Treiberbausteine benötigt. Das mittels des jeweiligen Treiberbausteins erzeugte Ansteuersignal wird das Gate eines als IGBT realisierten Leistungsschalters zugeführt, wobei das Gate des IGBT vom Mikrocontroller galvanisch getrennt ist.

Es ist bereits bekannt, diese galvanische Trennung durch einen hybriden bzw. Sandwich-Aufbau eines Optokopplers zu realisieren, wobei Leuchtdioden und zugehörige Optoaufnehmer zur Anwendung kommen.

Aus US-A 3,829,719 ist eine Schaltungsanordnung mit einem magnetfeldabhängigen Widerstand und einer Stabilisierungswicklung bekannt. Stabilisierungswicklung und magnetfeldabhängiger Widerstand befinden sich sekundärseitig in einem von einer primärseitigen Kontrollwicklung erzeugten Magnetfeld.

Weiterhin ist aus der DE 197 18 420 A1 bereits eine integrierte Datenübertragungsschaltung mit Potentialtrennung zwischen Ein- und Ausgangsschaltkreis bekannt. Dieser werden eingangsseitig binäre Eingangssignale zugeführt, die unter Verwendung eines innerhalb der integrierten Datenübertragungsschaltung angeordneten magnetosensitiven Koppelelementes übertragen und am Ausgang der integrierten Datenübertragungsschaltung als binäre Ausgangssignale zur Verfügung gestellt werden.

Der Erfindung liegt die Aufgabe zugrunde, einen integrierten Schaltkreis zur Erzeugung eines Ansteuersignals für einen IGBT anzugeben, dessen Aufbau vereinfacht ist.

Diese Aufgabe wird durch einen integrierten Schaltkreis mit den im Anspruch 1 angegebenen Merkmalen gelöst. Vorteilhafte Ausgestaltungen und Weiterbildungen der Erfindung sind in den abhängigen Ansprüchen angegeben.

Die Vorteile der Erfindung bestehen neben einem vereinfachten Aufbau auch in einer kostengünstigeren Produktion von integrierten Schaltkreisen gemäß der Erfindung sowie im Erreichen kürzerer Schaltkreisen. Weiterhin sind bei einem integrierten Schaltkreis gemäß der Erfindung Zusatzfunktionen, beispielsweise Diagnosefunktionen oder Überwachungsfunktionen, vergleichsweise einfach zu implementieren.

Weitere vorteilhafte Eigenschaften der Erfindung ergeben sich aus der Erläuterung von Ausführungsbeispielen anhand der Figuren. Es zeigt:
Figur 1 ein Ausführungsbeispiel zur Erläuterung der Erfindung und
Figur 2 ein Ausführungsbeispiel für die Erfindung.

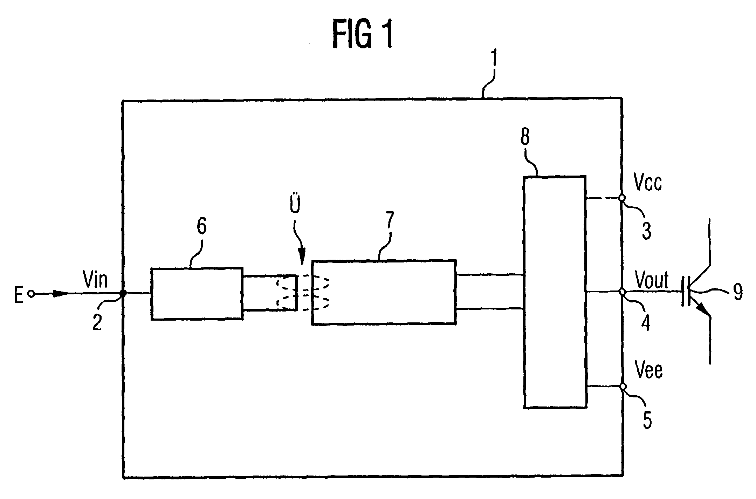

Die Figur 1 zeigt ein erstes Ausführungsbeispiel für einen integrierten Treiberbaustein, welcher an seinem Ausgang 4 ein Ansteuersignal Vₒᵤₜ für einen IGBT zur Steuerung von bürstenlosen Gleichstrom- und Wechselstrom-Motoren zur Verfügung stellt.

Der in Form eines integrierten Schaltkreises 1 vorliegende Treiberbaustein weist Anschlüsse 2, 3, 4 und 5 auf. Beim Anschluß 2 handelt es sich um einen Eingangsanschluß, dem ein an einem Eingang E bereitgestelltes Eingangssignal Vᵢₙ zugeführt wird, welches ein in einem Mikrocontroller erzeugtes Signal ist und mittels des Treiberbausteins in ein zur IGBT-Ansteuerung geeignetes Signal Vₒᵤₜ umgewandelt werden soll. Der Anschluß 3 ist ein Eingangsanschluß für eine von einer Spannungsquelle abgeleitete Versorgungsspannung V_{cc}. Beim Anschluß 4 handelt es sich um einen Ausgangsanschluß für das bereits oben genannte Ansteuersignal Vₒᵤₜ. Der Anschluß 5 ist ein Anschluß für eine Bezugsspannung Vₑₑ, vorzugsweise ein Masseanschluß. Das vom Mikrocontroller erzeugte Eingangssignal Vᵢₙ wird innerhalb des integrierten Schaltkreises 1 zunächst einer Senderlogik 6 zugeführt. Diese hat die Aufgabe, das genannte Eingangssignal Vᵢₙ in ein Stromsignal umzuwandeln, welches sich besonders gut für eine magnetosensitive Übertragung eignet. Zu diesem Zweck kann in der Senderlogik 6 beispielsweise eine Signalinversion erfolgen.

An die Senderlogik 6 ist ein Übertrager Ü angeschlossen, welcher zu einer magnetosensitiven Übertragung des Ausgangssignals der Senderlogik vorgesehen ist. Diese magnetosensitive Übertragung wird durchgeführt, um eine Potentialtrennung zwischen der Mikrocontrollerseite und der Motorseite der Schaltung zu erreichen. Die Notwendigkeit dieser Potentialtrennung ergibt sich daraus, daß die Mikrocontrollerseite und die Motorseite auf unterschiedliche Referenzpotentiale bezogen sind.

Der Übertrager Ü weist eingangsseitig eine Leiterschleife auf, über welche das in digitaler Form vorliegende Ausgangssignal der Senderlogik 6 geführt wird. Durch dieses digitale Signal wird im Umgebungsbereich der Leiterschleife ein sich in Abhängigkeit vom digitalen Signal änderndes Magnetfeld erzeugt, das in der Figur 1 durch die gestrichelten Linien angedeutet ist. Dieses sich ändernde Magnetfeld wird von einem Magnetfelddetektor bzw. magnetosensitiven Empfänger 7 erkannt, welcher durch einen Isolator von der Leiterschleife getrennt ist, sich aber im Bereich des genannten Magnetfeldes befindet.

Der Magnetfelddetektor der Vorrichtung zur Potentialtrennung kann in Form eines Hallelementes realisiert sein. Weiterhin kann es sich bei dem genannten Magnetfelddetektor auch um einen AMR-Sensor handeln (anisotropic magnetic resistance), der auf ein sich änderndes magnetisches Feld mit einer Widerstandsveränderung reagiert. Derartige AMR-Sensoren weisen eine Permalloyschicht auf.

Zur Verbesserung der Sensitivität des Magnetfelddetektors kann dieser auch in Form eines GMR-Sensors realisiert sein (giant magnetic resistance). Derartige GMR-Sensoren weisen eine Kombination dreier Schichten auf, von denen zwei weichmagnetisch sind und eine hartmagnetisch ist.

Eine nochmalige Verbesserung der Sensitivität des Magnetfelddetektors ist dadurch möglich, daß dieser als TMR-Sensor realisiert ist (tunnelling magnetic resistance). Bei diesem ist die hartmagnetische Schicht durch eine isolierende Schicht ersetzt.

Das vom magnetosensitiven Empfänger 7 detektierte Signal wird als galvanisch von der Eingangsseite getrenntes digitales Signal einem Steuerblock 8 zugeführt. Dieser ist weiterhin mit dem Anschluß 3 für die Versorgungsspannung V_{cc} und dem Anschluß 5 für die Bezugsspannung Vₑₑ verbunden. Ausgangsseitig stellt der Steuerblock 8 ein Ansteuersignal für das Gate eines IGBT 9 zur Verfügung.

Bei dem in Figur 1 gezeigten Ausführungsbeispiel ist nach alledem in einen als Treiberbaustein für einen IGBT vorgesehenen integrierten Schaltkreis außer einem Steuerblock 8 auch ein magnetosensitiver Übertrager zur Potentialtrennung zwischen der Mikrocontrollerseite und der Motorseite implementiert. Dies vereinfacht den Schaltungsaufbau, ermöglicht eine kostengünstigere Produktion von IGBT-Ansteuerschaltungen, erlaubt schnellere Schaltzeiten und eine vereinfachte Integration von weiteren Diagnose-, Überwachungs- und Logikbausteinen.

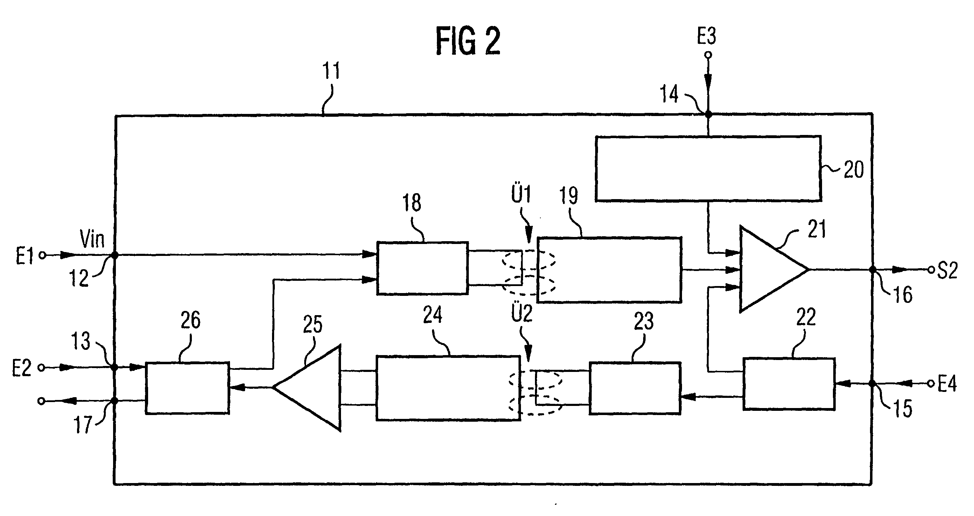

Die Figur 2 zeigt ein zweites Ausführungsbeispiel für einen integrierten Treiberbaustein, welcher an seinem Ausgang 16 ein Ansteuersignal S2 für die Basis eines nicht gezeichneten, außerhalb des integrierten Schaltkreises 11 angeordneten IGBTs zur Verfügung stellt. Dieser externe IGBT steuert einen angeschlossenen Motor an.

Der in Form eines integrierten Schaltkreises 11 vorliegende Treiberbaustein weist Anschlüsse 12, 13, 14, 15, 16, 17 auf. Beim Anschluß 12 handelt es sich um einen Eingangsanschluß, dem ein an einem Eingang E1 bereitgestelltes Eingangssignal Vᵢₙ zugeführt wird, welches ein in einem Mikrocontroller erzeugtes Signal ist und mittels des Treiberbausteins in ein Ansteuersignal für einen IGBT umgewandelt werden soll. Der Anschluß 13 ist ein Eingangsanschluß für ein mittels des Mikrocontrollers erzeugtes Reset-Signal, welches am Eingang E2 zur Verfügung steht. Beim Anschluß 14 handelt es sich um einen Eingangsanschluß für ein Signal einer motorseitigen Spannungsüberwachung, welches der dargestellten Vorrichtung über den Eingang E3 zugeführt wird. Über den Eingangsanschluß 15 wird dem integrierten Schaltkreis 11 ein vom Kollektor des externen IGBT abgeleitetes Eingangssignal zugeleitet, welches am Eingang E4 vorliegt. Beim Anschluß 16 handelt es sich um einen Ausgangsanschluß des integrierten Schaltkreises 11, an welchem das bereits oben genannte Ansteuersignal S2 für den externen IGBT ausgegeben wird. Der Anschluß 17 ist ein Ausgangsanschluß für ein Fehlersignal, welches von dort aus dem Mikrocontroller zugeführt wird.

Das vom Mikrocontroller erzeugte Eingangssignal Vᵢₙ wird innerhalb des integrierten Schaltkreises 11 zunächst einer Senderlogik 18 zugeführt. Dieser hat die Aufgabe, das genannte Eingangssignal Vᵢₙ in ein Stromsignal umzuwandeln, welches sich besonders gut für einen magnetosensitive Übertragung eignet. Zu diesem Zweck kann in der Senderlogik beispielsweise eine Signalinversion erfolgen.

An die Senderlogik 18 ist ein Übertrager Ü1 angeschlossen, welcher zu einer magnetosensitiven Übertragung des Ausgangssignals der Senderlogik vorgesehen ist. Diese magnetosensitive Übertragung wird durchgeführt, um eine Potentialtrennung zwischen der Mikrocontrollerseite und der Motorseite der Schaltung zu erreichen. Die Notwendigkeit dieser Potentialtrennung ergibt sich daraus, daß die Mikrocontrollerseite und die Motorseite auf unterschiedliche Referenzpotentiale bezogen sind.

Der Übertrager Ü1 ist ebenso ausgebildet wie der oben im Zusammenhang mit der Figur 1 beschriebene Übertrager Ü.

Das vom magnetosensitiven Empfänger 19 detektierte Signal wird als galvanisch von der Eingangsseite getrenntes digitales Signal einem Eingang eines Treiberverstärkers 21 zugeführt. Einem weiteren Eingang dieses Treiberverstärkers 21 wird ein Ausgangssignal des Schaltungsblockes 20 zugeführt, der die motorseitige Spannung überwacht und gegebenenfalls für ein sofortiges Abschalten des Motors sorgt. Weiterhin ist der Treiberverstärker 21 eingangsseitig mit einem Fehlerdetektor 22 verbunden, dem das am Eingang 15 anliegende, vom Kollektor des externen IGBT abgeleitete Eingangssignal zugeführt wird. Der Fehlerdetektor 22 überwacht das genannte Eingangssignal und sorgt beispielsweise bei Überstrom für ein sanftes Abschalten des Motors.

Am Ausgang des Treiberverstärkers 21 wird das Ansteuersignal S2 für den externen IGBT zur Verfügung gestellt und an diesen über den Ausgangsanschluß 16 des integrierten Schaltkreises 11 weitergeleitet.

Der Fehlerdetektor 22 ist ausgangsseitig weiterhin mit einer Senderlogik 23 verbunden. Diese hat die Aufgabe, daß das Vorliegen eines Fehlers anzeigende Ausgangssignal des Fehlerdetektors 22 in ein Stromsignal umzuwandeln, welches sich besonders gut für eine magnetosensitive Übertragung eignet.

An die Senderlogik 23 ist ein Übertrager Ü2 angeschlossen, welcher zu einer magnetosensitiven Übertragung des Ausgangssignals der Senderlogik 23 vorgesehen ist. Diese magnetosensitive Übertragung wird durchgeführt, um eine Potentialtrennung zwischen der Motorseite, auf welcher das am Eingang 15 anliegende Signal erzeugt wird, und der Mikrocontrollerseite, auf welcher das am Ausgang 17 zur Verfügung gestellte Signal vorliegt, zu erreichen.

Der Übertrager Ü2 ist ebenso ausgebildet wie der oben im Zusammenhang mit der Figur 1 beschriebene Übertrager Ü.

Das vom magnetosensitiven Empfänger 24 detektierte Signal wird als galvanisch von der Motorseite getrenntes Signal in einem Verstärker 25 verstärkt und über einen Fehlersignal-Zwischenspeicher 26 und den Ausgang 17 des integrierten Schaltkreises 11 dem externen Mikrocontroller zugeführt.

Das am Eingang 13 des integrierten Schaltkreises vorliegende Signal ist ein Reset-Signal und zur mikrocontrollergesteuerten Rücksetzung des Fehlersignal-Zwischenspeichers 26 vorgesehen.

Ein weiterer Ausgang des Fehlersignal-Zwischenspeichers ist mit einem Eingang der Senderlogik 18 verbunden, um auf diese Weise beim Vorliegen eines Fehlers zusätzlich auf das Ansteuersignal des IGBT einzuwirken und dadurch ein erneutes Anlaufen des Motors zu verhindern.

Bei dem in Figur 2 gezeigten Ausführungsbeispiel sind nach alledem in einen als Treiberbaustein für einen Motor vorgesehenen integrierten Schaltkreis außer einem Treiberverstärker 21, einem Fehlerdetektor für mikrocontrollerseitige Fehler und einem Fehlerdetektor für motorseitige Fehler auch zwei magnetosensitive Übertrager Ü1 und Ü2 zur Potentialtrennung zwischen der Mikrocontrollerseite und der Motorseite integriert. Dies vereinfacht den Schaltungsaufbau, ermöglicht eine kostengünstige Produktion von Motoransteuerschaltungen, erlaubt schnellere Schaltzeiten und erlaubt - wie aus dem gezeigten Ausführungsbeispiel ersichtlich ist - eine einfache Integration von zusätzlichen Diagnose-, Überwachungs- und Lo-gikbausteinen.

Unter Verwendung von integrierten Schaltkreisen gemäß der Erfindung können sowohl Gleichstrom- als auch Wechselstrommotoren angesteuert werden.

## Patentansprüche

1. Integrierter Schaltkreis zur Erzeugung eines Ansteuersignals für einen IGBT mit einem Eingangsanschluß für ein mittels eines Mikrocontrollers erzeugtes Steuersignal und einem vom Eingangsanschluß zu einer Steuersignalverarbeitungseinheit geführten Steuersignalpfad, **dadurch gekenzeichnet, daß** der integrierte Schaltkreis (1, 11) im Steuersignalpfad eine erste magnetosensitive Vorrichtung (Ü, Ü1) zur Potentialtrennung, einen Eingangsanschluss (15) für ein vom Kollektor des IGBT abgeleitetes Signal und eine zweite magnetosensitive Vorrichtung (Ü2) zur Übertragung des vom Kollektor des IGBT abgeleiteten Signals aufweist.

2. Integrierter Schaltkreis nach Anspruch 1, **dadurch gekennzeichnet, daß** er zwischen dem Eingangsanschluß (2, 12) und der ersten magnetosensitiven Vorrichtung (Ü, Ü1) zur Potentialtrennung eine Senderlogik (6, 18) aufweist.

3. Integrierter Schaltkreis nach Anspruch 1 oder 2, **dadurch gekennzeichnet, daß** die erste magnetosensitive Vorrichtung (Ü, Ü1) eingangsseitig eine Leiterschleife und ausgangsseitig ein Magnetfelddetektorelement (7, 19) aufweist.

4. Integrierter Schaltkreis nach Anspruch 3, **dadurch gekennzeichnet, daß** das Magnetfelddetektorelement ein Hallelement ist.

5. Integrierter Schaltkreis nach Anspruch 3, **dadurch gekennzeichnet, daß** das Magnetfelddetektorelement ein anisotropes, magnetoresistives Bauelement (AMR) ist.

6. Integrierter Schaltkreis nach Anspruch 3, **dadurch gekennzeichnet, daß** das Magnetfelddetektorelement ein giant magnetoresistives Bauelement (GMR) ist.

7. Integrierter Schaltkreis nach Anspruch 3, **dadurch gekennzeichnet, daß** das Magnetfelddetektorelement ein tunnel-magnetosensitives Bauelement (TMR) ist.

8. Integrierter Schaltkreis nach einem der Ansprüche 1-7, **dadurch gekennzeichnet, daß** er einen Ausgangsanschluß (16) für ein Ansteuersignal (S2) für einen externen IGBT aufweist.

9. Integrierter Schaltkreis nach Anspruch 8, **dadurch gekennzeichnet, daß** er einen Treiberverstärker (21) aufweist, der das Ansteuersignal dem IGBT zur Verfügung stellt.

10. Integrierter Schaltkreis nach einem der vorhergehenden Ansprüche, **dadurch gekennzeichnet, daß** er einen integrierten Fehlerdetektor (20, 22) aufweist.

11. Integrierter Schaltkreis nach Anspruch 10, **dadurch gekennzeichnet, daß** der Fehlerdetektor zur Detektion mikrocontrollerseitiger Fehler vorgesehen ist.

12. Integrierter Schaltkreis nach Anspruch 10 oder 11, **dadurch gekennzeichnet, daß** der Fehlerdetektor (20, 22) zur Detektion motorseitiger Fehler vorgesehen ist.

13. Integrierter Schaltkreis nach Anspruch 12, **dadurch gekennzeichnet, daß** der Fehlerdetektor (22) ausgangsseitig mit der zweiten magnetosensitiven Vorrichtung (Ü2) zur Potentialtrennung verbunden ist, die ausgangsseitig mit einem Ausgangsanschluß (17) des integrierten Schaltkreises verbunden ist.

14. Integrierter Schaltkreis nach Anspruch 13, **dadurch gekennzeichnet, daß** die zweite magnetosensitive Vorrichtung (Ü2) zur Potentialtrennung ausgangsseitig über einen Fehlersignal-Zwischenspeicher (26) mit dem Ausgangsanschluß (17) verbunden ist.

15. Integrierter Schaltkreis nach Anspruch 14, **dadurch gekennzeichnet, daß** im Signalweg des Fehlersignals zwischen der zweiten magnetosensitiven Vorrichtung (Ü2) zur Potentialtrennung und dem Ausgangsanschluß (17) ein Verstärker (25) vorgesehen ist.

16. Integrierter Schaltkreis nach Anspruch 14 oder 15, **dadurch gekennzeichnet, daß** der Fehlersignal-Zwischenspeicher (26) eingangsseitig mit einem Eingangsanschluß (13) des integrierten Schaltkreises für ein Reset-Signal verbunden ist.

17. Integrierter Schaltkreis nach einem der Ansprüche 14-16, **dadurch gekennzeichnet, daß** der Fehlersignal-Zwischenspeicher (26) ausgangsseitig mit einem Eingang der im Steuersignalpfad vorgesehenen Senderlogik (18) verbunden ist.

## Claims

1. Integrated circuit for generating a drive signal for an IGBT, having an input terminal for a control signal generated by means of a microcontroller and a control signal path routed from the input terminal to a control signal processing unit, **characterised in that** the integrated circuit (1, 11) has, in the control signal path, a first magneto-sensitive device (Ü, Ü1) for galvanic isolation, an input terminal (15) for a signal derived from the collector of the IGBT and a second magneto-sensitive device (Ü2) for transmitting the signal derived from the collector of the IGBT.

2. Integrated circuit according to claim 1,
**characterised in that** it has a transmitter logic (6, 18) between the input terminal (2, 12) and the first magneto-sensitive device (Ü, Ü1) for galvanic isolation.

3. Integrated circuit according to claim 1 or 2,
**characterised in that** the first magneto-sensitive device (Ü, Ü1) has a conductor loop on the input side and a magnetic field detector element (7, 19) on the output side.

4. Integrated circuit according to claim 3,
**characterised in that** the magnetic field detector element is a Hall element.

5. Integrated circuit according to claim 3,
**characterised in that** the magnetic field detector element is an anisotropic magneto-resistive (AMR) component.

6. Integrated circuit according to claim 3,
**characterised in that** the magnetic field detector element is a giant magneto-resistive (GMR) component.

7. Integrated circuit according to claim 3,
**characterised in that** the magnetic field detector element is a tunnel magneto-sensitive (TMR) component.

8. Integrated circuit according to one of the claims 1-7,
**characterised in that** it has an output terminal (16) for a drive signal (S2) for an external IGBT.

9. Integrated circuit according to claim 8,
**characterised in that** it has a driver amplifier (21) which provides the drive signal to the IGBT.

10. Integrated circuit according to one of the preceding claims, **characterised in that** it has an integrated fault detector (20, 22).

11. Integrated circuit according to claim 10,
**characterised in that** the fault detector is provided for detecting faults on the microcontroller side.

12. Integrated circuit according to claim 10 or 11,
**characterised in that** the fault detector (20, 22) is provided for detecting faults on the motor side.

13. Integrated circuit according to claim 12,
**characterised in that** on its output side the fault detector (22) is connected to the second magneto-sensitive device (Ü2) for galvanic isolation which is connected on its output side to an output terminal (17) of the integrated circuit.

14. Integrated circuit according to claim 13,
**characterised in that** the second magneto-sensitive device (Ü2) for galvanic isolation is connected on its output side to the output terminal (17) via a fault signal buffer (26).

15. Integrated circuit according to claim 14,
**characterised in that** an amplifier (25) is provided in the signal path of the fault signal between the second magneto-sensitive device (Ü2) for galvanic isolation and the output terminal (17).

16. Integrated circuit according to claim 14 or 15,
**characterised in that** the fault signal buffer (26) is connected on the input side to an input terminal (13) of the integrated circuit for a reset signal.

17. Integrated circuit according to one of the claims 14-16, **characterised in that** the fault signal buffer (26) is connected on the output side to an input of the transmitter logic (18) provided in the control signal path.

## Revendications

1. Circuit intégré de production d'un signal de commande d'un IGBT, ayant une borne d'entrée d'un signal de commande produit au moyen d'un microrégisseur et un trajet de signal de commande allant de la borne d'entrée à une unité de traitement du signal de commande, **caractérisé en ce que** le circuit (1, 11) intégré a, dans le trajet du signal de commande, un premier dispositif (Ü, Ü1) magnétosensible de séparation de potentiel, une borne (15) d'entrée d'un signal dérivé du collecteur de l'IGBT et un deuxième dispositif (Ü2) magnétosensible de transmission du signal dérivé du collecteur de l'IGBT.

2. Circuit intégré suivant la revendication 1, **caractérisé en ce qu'**il a, entre la borne (2, 12) d'entrée et le premier dispositif (Ü, Ü1) magnétosensible, une logique (6, 18) d'émetteur pour la séparation de potentiel.

3. Circuit intégré suivant la revendication 1 ou 2, **caractérisé en ce que** le premier dispositif (Ü, Ü1) magnétosensible a, du côté entrée, une boucle conductrice et, du côté sortie, un élément (7, 19) de détection du champ magnétique.

4. Circuit intégré suivant la revendication 3, **caractérisé en ce que** l'élément de détection du champ magnétique est un élément de Hall.

5. Circuit intégré suivant la revendication 3, **caractérisé en ce que** l'élément de détection du champ magnétique est un composant (AMR) magnétorésistant.

6. Circuit intégré suivant la revendication 3, **caractérisé en ce que** l'élément de détection du champ magnétique est un composant (GMR) magnétorésistant géant.

7. Circuit intégré suivant la revendication 3, **caractérisé en ce que** l'élément de détection du champ magnétique est un composant (TMR) tunnel-magnétosensible.

8. Circuit intégré suivant l'une des revendications 1 à 7, **caractérisé en ce qu'**il a une borne (16) de sortie d'un signal (S2) de commande d'un IGBT extérieur.

9. Circuit intégré suivant la revendication 8, **caractérisé en ce qu'**il a un amplificateur (21) d'attaque, qui met le signal de commande à la disposition de l'IGBT.

10. Circuit intégré suivant l'une des revendications précédentes, **caractérisé en ce qu'**il a un détecteur (20, 22) intégré d'erreur.

11. Circuit intégré suivant la revendication 10, **caractérisé en ce que** le détecteur d'erreur est prévu pour la détection d'erreur côté microrégisseur.

12. Circuit intégré suivant la revendication 10 ou 11, **caractérisé en ce que** le détecteur (20, 22) d'erreur est prévu pour la détection d'erreurs côté moteur.

13. Circuit intégré suivant la revendication 12, **caractérisé en ce que** le détecteur (22) d'erreur est relié côté sortie au deuxième dispositif (Ü2) magnétosensible pour la séparation de potentiel, qui est relié côté sortie à une borne (17) de sortie du circuit intégré.

14. Circuit intégré suivant la revendication 13, **caractérisé en ce que** le deuxième dispositif (Ü2) magnétosensible pour la séparation du potentiel est relié côté sortie à la borne (17) de sortie par une mémoire (26) intermédiaire de signal d'erreur.

15. Circuit intégré suivant la revendication 14, **caractérisé en ce qu'**il est prévu un amplificateur (25) dans le trajet du signal d'erreur entre le deuxième dispositif (Ü2) magnétosensible de séparation du potentiel et la borne (17) de sortie.

16. Circuit intégré suivant la revendication 14 ou 15, **caractérisé en ce que** la mémoire (26) intermédiaire de signal d'erreur est reliée côté entrée à une borne (13) d'entrée du circuit intégré pour un signal de remise à l'état initial.

17. Circuit intégré suivant l'une des revendications 14 à 16, **caractérisé en ce que** la mémoire (26) intermédiaire du signal d'erreur est reliée côté sortie à une entrée de la logique (18) d'émetteur prévue dans le trajet du signal de commande.
